# DEMANDE DE BREVET EUROPEEN

(11) **EP 1 061 650 A1**
(43) Date de publication de la demande: **20.12.2000**
(21) Numéro de dépôt: 00410059.0
(22) Date de dépôt: 16.06.2000
(51) Int. Cl.: H03K 17/725

(54) **Commutateur bidirectionnel haute tension bistable**

(30) Priorité: 18.06.1999 FR 9907977
(71) Demandeur: STMicroelectronics SA, 94250 Gentilly Cedex (FR)
(72) Inventeur: Rault, Pierre, 37540 Saint Cyr sur Loire (FR)
(74) Mandataire: de Beaumont, Michel

(57) **Abrégé**

L'invention concerne un commutateur bidirectionnel haute tension (20), comportant un élément (K) de commutation bidirectionnel haute tension, et des moyens (21) pour rendre l'élément de commutation bistable et commandable par au plus deux signaux impulsionnels (V_{ON/OFF}) basse tension.

## Description

La présente invention concerne le domaine des commutateurs bidirectionnels haute tension commandables par un signal basse tension. La présente invention concerne, plus particulièrement, des commutateurs bidirectionnels destinés à être connectés en série avec une charge alimentée par une haute tension alternative, par exemple, le secteur et, parmi ceux-ci, les commutateurs qui sont ouvrables et fermables sur commande.

Des commutateurs haute tension pour charge alternative du type de ceux auxquels se rapporte la présente invention sont utilisés, en particulier, chaque fois que l'on a besoin d'un circuit d'interface entre un système de commande basse tension, par exemple, un microcontrôleur, et une charge devant être alimentée par une haute tension alternative, par exemple, un moteur, une résistance chauffante, etc.

Un exemple d'application de la présente invention concerne les appareils électroménagers, par exemple, des machines à laver, dans lesquels plusieurs charges (moteurs, pompes, résistances chauffantes, vannes) doivent être commandées à partir du microcontrôleur de la machine.

Généralement, un commutateur bidirectionnel propre à être commandé par un signal basse tension est constitué d'un triac dont les deux bornes de puissance sont sur la ligne d'alimentation de la charge et dont la gâchette reçoit un signal de commande basse tension.

Un problème qui se pose avec un triac est qu'il doit être amorcé à chaque alternance de la tension d'alimentation car il se bloque par disparition du courant entre ses deux bornes de puissance. De plus, il n'est généralement pas possible de commander le triac par un signal impulsionnel à la fréquence du secteur, en particulier pour de faibles charges, dans la mesure où les courants de maintien et de déclenchement du triac sont alors du même ordre de grandeur (la dizaine de milliampères) que le courant dans la charge. Par conséquent, dans les systèmes classiques, on applique un signal continu sur la gâchette du triac pendant toute la durée où il doit être fermé.

Un inconvénient est que ce signal continu, généralement fourni par un microcontrôleur qui tire son énergie d'une alimentation basse tension, entraîne une consommation permanente.

Un autre inconvénient est que le circuit d'alimentation dissipe alors fortement dans la mesure où on utilise le plus souvent une conversion de tension depuis la tension d'alimentation alternative (par exemple, le secteur).

Enfin, lorsqu'un ou plusieurs triacs sont destinés à être commandés par un microcontrôleur, cette commande par des signaux continus sur toute la durée des périodes de fermeture monopolise le microcontrôleur.

Il serait souhaitable de disposer d'un commutateur bidirectionnel haute tension qui puisse être commandé par un signal basse tension sans engendrer de dissipation importante de la part du circuit de commande.

Il serait également souhaitable de minimiser le temps de recours au microcontrôleur de commande éventuel.

Ainsi, la présente invention vise à proposer un nouveau commutateur bidirectionnel haute tension de commande d'une charge alternative qui puisse être commandé par impulsions basse tension de sorte qu'une première impulsion puisse provoquer la fermeture du commutateur et que le commutateur reste fermé jusqu'à ce qu'une deuxième impulsion provoque son ouverture. Il s'agit donc d'un commutateur bistable.

La présente invention vise également à proposer un commutateur dans lequel la dissipation d'énergie et la consommation sont minimisées.

Pour atteindre ces objets, la présente invention prévoit un commutateur bidirectionnel haute tension, comprenant un élément de commutation bidirectionnel haute tension ; et des moyens pour rendre l'élément de commutation bistable et commandable par au plus deux signaux impulsionnels basse tension.

Selon un mode de réalisation de la présente invention, la fréquence des signaux impulsionnels est faible devant la fréquence de la haute tension alternative, la durée des impulsions étant faible devant la période de cette haute tension alternative.

Selon un mode de réalisation de la présente invention, lesdits moyens comportent deux interrupteurs et un condensateur pour stocker une énergie suffisante pour réamorcer l'élément de commutation bidirectionnel à chaque alternance de la haute tension.

Selon un mode de réalisation de la présente invention, le condensateur est connecté en série avec une résistance et un premier interrupteur entre deux bornes du commutateur propres à recevoir la haute tension alternative, le premier interrupteur étant destiné à provoquer, par sa fermeture, la fermeture de l'élément de commutation bidirectionnel.

Selon un mode de réalisation de la présente invention, un deuxième interrupteur est connecté en série avec une deuxième résistance, cette connexion en série étant connectée en parallèle avec la connexion en série du condensateur et du premier interrupteur, le deuxième interrupteur étant destiné, lors de sa fermeture, à décharger le condensateur pour empêcher un réamorçage automatique de l'élément de commutation bidirectionnel.

Selon un mode de réalisation de la présente invention, les deux interrupteurs sont commandés par un signal de commande unique, chaque interrupteur étant unidirectionnel et correspondant à un sens particulier de conduction.

Selon un mode de réalisation de la présente invention, le signal unique de commande est synchronisé sur la haute tension alternative, les impulsions apparaissant lors d'un premier signe des alternances étant destinées à provoquer la fermeture du commutateur et les impulsions apparaissant lors d'un deuxième signe d'alternance étant destinées à provoquer son ouverture.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 représente, sous forme de schéma-blocs, un mode de réalisation d'un commutateur bidirectionnel haute tension selon un premier aspect de la présente invention ;
la figure 2 représente, de façon schématique, un premier mode de réalisation du commutateur de la figure 1 ;
la figure 3 représente un deuxième mode de réalisation d'un commutateur selon le premier aspect de l'invention ;
les figures 4A à 4D illustrent, sous forme de chronogrammes, le fonctionnement du commutateur de la figure 3 ;
la figure 5 représente partiellement un troisième mode de réalisation d'un commutateur selon le premier aspect de l'invention ;
la figure 6 représente, sous forme de blocs, un mode de réalisation d'un commutateur selon un deuxième aspect préféré de la présente invention ;
la figure 7 représente un premier mode de réalisation d'un commutateur selon le deuxième aspect de l'invention ;
la figure 8 est une vue partielle d'un détail de la figure 7 selon un deuxième mode de réalisation du commutateur selon le deuxième aspect de l'invention ; et
les figures 9A à 9C illustrent, sous forme de chronogrammes, le fonctionnement d'un commutateur selon le deuxième aspect de l'invention.

Les mêmes éléments ont été désignés par les mêmes références aux différentes figures. Pour des raisons de clarté, seuls les éléments qui sont nécessaires à la compréhension de l'invention ont été représentés aux figures et seront décrits par la suite. En particulier, la charge alternative devant être commandée par le commutateur de l'invention n'a pas été détaillée et ne fait pas l'objet de la présente invention.

Une caractéristique de la présente invention est d'associer, pour réaliser un commutateur bidirectionnel haute tension susceptible d'être commandé par un signal basse tension, un élément de commutation bidirectionnel classique à des moyens pour rendre le commutateur bistable et commandable, au plus, par deux signaux impulsionnels basse tension.

Une autre caractéristique de la présente invention est que l'énergie nécessaire à maintenir le commutateur dans un état donné est prise sur la haute tension d'alimentation alternative.

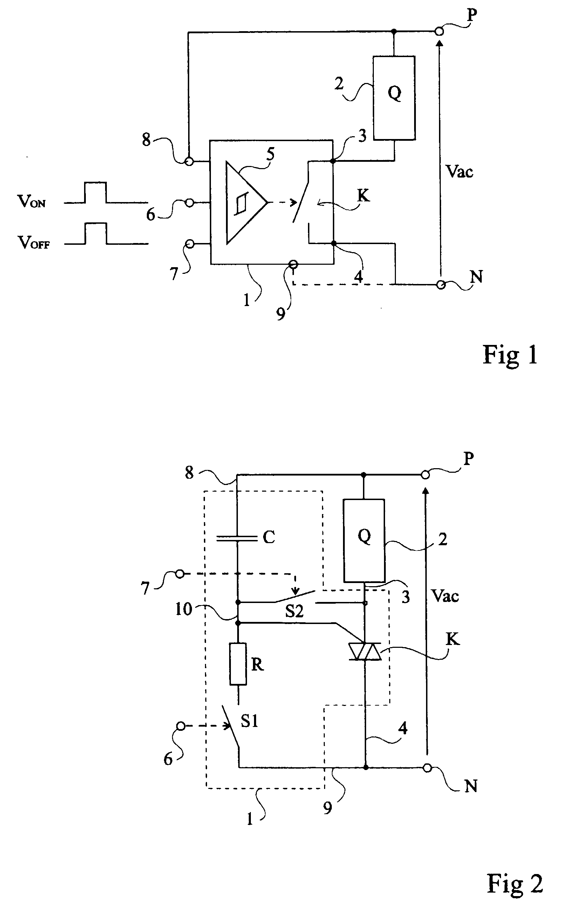

La figure 1 représente un mode de réalisation d'un commutateur 1 selon un premier aspect de l'invention. Ce commutateur est destiné à être commandé par deux signaux impulsionnels basse tension V_{ON}, V_{OFF} selon que l'on souhaite basculer le commutateur vers son état ouvert ou son état fermé.

Le commutateur 1 comprend essentiellement un élément K de commutation bidirectionnel haute tension propre à être connecté en série avec une charge 2 (Q) à commander. Ainsi, le commutateur 1 comprend deux bornes 3, 4 de puissance destinées à être intercalées sur une ligne d'alimentation de la charge 2, par exemple, entre une borne de la charge 2 et le neutre N d'une tension d'alimentation alternative Vac, l'autre borne de la charge 2 étant reliée à la phase P de la tension Vac.

L'élément de commutation K est, de préférence, un triac qui constitue un mode de réalisation particulièrement simple d'un commutateur bidirectionnel haute tension.

L'élément K est commandé par un circuit 5 propre à maintenir son état fermé ou ouvert même après disparition d'un signal de commande ayant provoqué cet état en étant appliqué sur une des deux bornes 6, 7 d'entrée basse tension du commutateur 1.

En outre, le commutateur 1 comporte une borne 8 connectée, dans cet exemple, à la phase P de l'alimentation alternative. La borne 8 est destinée à fournir au circuit 5, le moyen de maintenir l'état de l'élément K à partir de la haute tension d'alimentation alternative. Le neutre est prélevé sur la borne 4 raccordée à une borne 9 du commutateur 1.

La figure 2 représente un premier mode de réalisation du commutateur 1. L'élément de commutation K est constitué d'un triac, dont les bornes de puissance définissent les bornes 3 et 4 du commutateur 1. Le circuit de commande 5 est ici constitué de deux interrupteurs SI et S2 connectés à un condensateur C et à une résistance R. Le condensateur C, la résistance R et l'interrupteur SI sont connectés en série entre les bornes 8 et 9 de la tension d'alimentation alternative Vac. L'interrupteur S2 est connecté entre un noeud 10, de connexion du condensateur C à la résistance R, et la borne 3. La gâchette du triac K est également connectée au noeud 10.

Dans le mode de réalisation de la figure 2, on suppose que l'interrupteur SI est commandé à partir du signal V_{ON} appliqué sur la borne 6, c'est-à-dire du signal de commande en fermeture du commutateur, tandis que l'interrupteur S2 est commandé à partir du signal V_{OFF} appliqué sur la borne 7, c'est-à-dire du signal de commande en ouverture du commutateur 1. Le fonctionnement du commutateur de la figure 2 est le suivant.

On suppose qu'initialement le condensateur C est déchargé et que les interrupteurs SI et S2 sont tous deux ouverts, aucune impulsion de commande n'étant appliquée sur les bornes 6 et 7. Par conséquent, lorsque la tension alternative Vac est appliquée entre les bornes P et N, aucun courant ne circule dans la charge 2. En effet, le condensateur C étant déchargé, aucun courant ne peut circuler depuis la borne de puissance 3 du triac K à travers sa gâchette et le triac ne peut donc pas s'amorcer.

Pour fermer le commutateur 1, on applique une impulsion sur la borne 6 de façon à provoquer la fermeture de l'interrupteur SI pendant une durée prédéterminée. Quand l'interrupteur S1 est fermé, un courant circule dans la charge 2, de la borne de puissance 3 du triac K à sa gâchette, dans la résistance R et dans l'interrupteur S1. La durée de l'impulsion de fermeture de l'interrupteur S1 est choisie en fonction du courant nécessaire à l'amorçage du triac K de façon que ce dernier soit amorcé avant que l'interrupteur S1 soit de nouveau ouvert par disparition de l'impulsion sur la borne 6.

Par la fermeture de l'interrupteur S1, le condensateur C se trouve chargé sensiblement à la masse N sur la borne 10 (en négligeant les chutes de tension dans la résistance R et dans l'interrupteur S1 à l'état fermé). On notera que le courant dans le condensateur C est déphasé de 90° par rapport à la tension Vac.

La durée de l'impulsion de fermeture de l'interrupteur SI est inférieure à la demi période de la tension Vac de sorte que cette impulsion a disparu à la fin de l'alternance de la tension Vac ayant provoqué l'amorçage du triac K. Quand la tension Vac de l'alternance suivante commence à croître (ou à décroître), un courant circule à travers le condensateur C soit parce que le potentiel de la borne N diminue (alternance négative) soit parce que le potentiel de la borne P augmente (alternance positive). Par conséquent, ce courant circulant à travers le condensateur C sert à réamorcer le triac K à chaque alternance. Pour un fonctionnement correct du commutateur 1 il faut que la capacité du condensateur C soit telle que celui-ci délivre un courant suffisant pour amorcer le triac à chaque alternance.

A titre d'exemple particulier de réalisation, pour un triac ayant un courant d'amorçage de l'ordre de 1 milliampère, et pour une tension Vac de 220 Volts à une fréquence de 50 Hertz, un condensateur C d'une capacité de l'ordre de 10 nF convient.

Le commutateur 1 reste fermé de façon stable, c'est-à-dire que le triac K est remis en conduction automatiquement à chaque alternance de l'alimentation Vac. De plus, la recharge du condensateur C à chaque alternance est obtenue en ne prélevant de l'énergie que sur la tension Vac.

On notera que l'invention tire profit du déphasage du courant dans le condensateur C par rapport à la tension Vac pour que le courant dans le condensateur ne soit jamais nul lors des passages par zéro de la tension Vac. Cette condition est nécessaire pour permettre le réamorçage du triac K à chaque alternance.

Pour ouvrir le commutateur 1, on applique une impulsion de durée prédéterminée sur la borne 7 de façon à provoquer la fermeture de l'interrupteur S2 pendant une durée suffisante pour décharger le condensateur C.

On notera que l'interrupteur S2 doit être fermé jusqu'à la fin de l'alternance de la tension Vac pour éviter que le condensateur C ne se recharge.

Comme le condensateur est déchargé, le commutateur 1 est alors de nouveau dans un état stable mais cette fois-ci ouvert.

En pratique, les interrupteurs S1 et S2 du commutateur de la figure 2 pourront être formés, par exemple, de triacs ou de thyristors. Pour la commande de l'interrupteur S2, on aura recours à un optocoupleur ou équivalent pour disposer d'une référence de tension permettant la commande du triac ou du thyristor constitutif de cet interrupteur. En effet, dans le montage de la figure 2, aucune des bornes de puissance de l'interrupteur S2 n'est connectée à un potentiel pouvant servir de référence commune avec celle du signal impulsionnel de commande comme c'est le cas pour l'interrupteur SI.

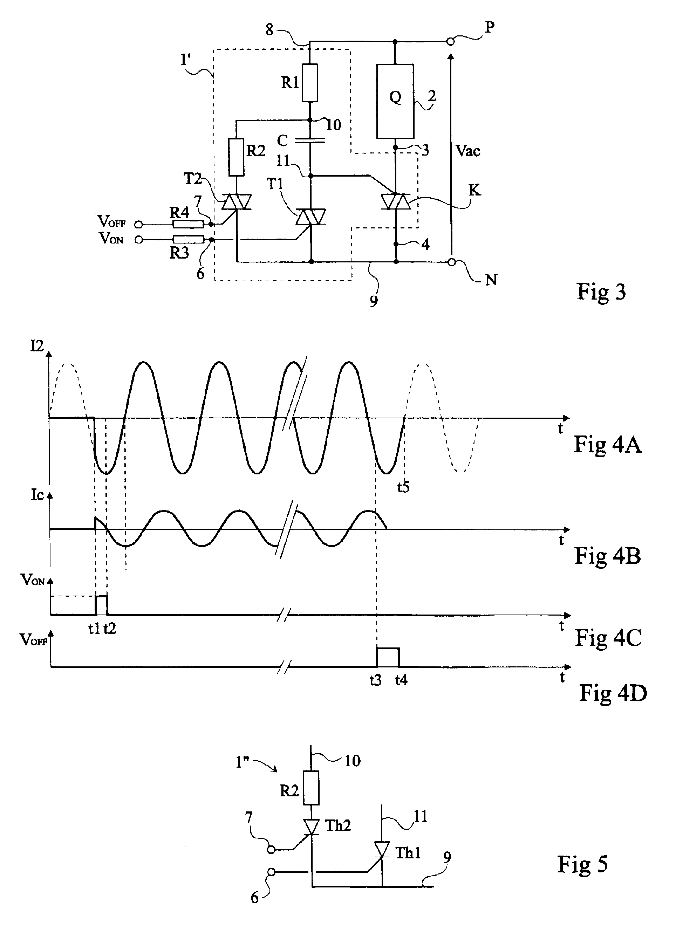

La figure 3 représente un deuxième mode de réalisation d'un commutateur 1' reprenant le premier aspect de l'invention illustré par la figure 1. Ce mode de réalisation a en particulier pour objet d'éviter le recours à un optocoupleur ou analogue pour la commande du deuxième interrupteur du commutateur 1 de la figure 2. Ce mode de réalisation a également pour but de minimiser la consommation du commutateur.

Comme précédemment, le commutateur 1' comporte un triac K dont les bornes de puissance définissent les bornes 3 et 4 du commutateur. Toujours comme dans le mode de réalisation de la figure 2, une résistance R1, un condensateur C et un premier interrupteur, ici un triac T1, sont connectés en série entre les bornes 8 et 9 du commutateur 1'. Toutefois, dans ce mode de réalisation, le condensateur C est placé au milieu de l'association en série, c'est-à-dire entre la résistance R1 et le triac T1. La gâchette du triac K est alors reliée au point commun 11 entre le triac T1 et le condensateur C.

Selon ce mode de réalisation, un deuxième interrupteur, ici un triac T2, est connecté en série avec une résistance R2 entre le noeud 10 de connexion de la résistance R1 au condensateur C, et la borne 9, une borne de puissance du triac T2 étant connectée à la borne 9.

Les gâchettes respectives des triacs T1 et T2 sont reliées aux bornes 6 et 7 du commutateur 1' qui reçoivent, par exemple par l'intermédiaire de résistances R3, R4 de conversion tension-courant, des tensions de commande impulsionnelles V_{ON} et V_{OFF}.

Le fonctionnement du commutateur 1' de la figure 3 est illustré par les figures 4A à 4D qui représentent, respectivement, un exemple d'allure des courants I₂ et Ic respectivement dans la charge 2 et dans le condensateur C, pour un exemple de signaux de commande V_{ON} et V_{OFF}.

A la figure 4A, on a symbolisé en pointillés l'allure du courant dans la charge 2 si celle-ci était en conduction permanente. Par souci de simplification, on a supposé que la charge 2 était une charge purement résistive, ce qui conduit à ce que le courant Ic dans le condensateur C est sensiblement déphasé de 90° par rapport au courant I₂ dans la charge. On notera toutefois que ceci n'a pas d'incidence sur le fonctionnement du commutateur pourvu que le courant dans le condensateur C soit différent de zéro quand la tension Vac passe par zéro.

On suppose qu'on applique une impulsion de tension V_{ON} positive entre des instants tl et t2 sur la borne 6. La fermeture du triac T1 à l'instant t1 provoque la circulation d'un courant dans la charge et dans le condensateur C. Le triac T1 s'ouvre au passage par zéro qui suit l'instant t2 et ne se referme pas à l'alternance suivante dans la mesure où l'impulsion de commande de la tension V_{ON} a disparu. Toutefois, le triac K est réamorcé à chaque alternance grâce au courant Ic dans le condensateur C.

On suppose qu'à un instant t3, une impulsion de tension V_{OFF} positive est appliquée sur la borne 7 pour entraîner l'ouverture du commutateur 1'. A l'instant t3, le triac T2 se ferme ce qui provoque la décharge du condensateur C en ramenant le noeud 10 sensiblement à la masse N. Le triac K s'ouvre à la fin de l'alternance qui suit (instant t5). Comme au début de l'alternance suivante le condensateur C est désormais déchargé et que le triac T1 est ouvert, le triac K ne se referme pas.

La figure 5 représente partiellement un troisième mode de réalisation d'un commutateur 1" selon le premier aspect de l'invention. Ce mode de réalisation diffère de celui exposé en relation avec la figure 3 par le fait que les triacs T1 et T2 sont remplacés par des thyristors Th1 et Th2. A la figure 5, seuls les thyristors et la résistance R2 ont été représentés, le reste du commutateur étant identique à celui de la figure 3.

Le choix entre des triacs ou des thyristors pour former les interrupteurs de l'élément de commande du commutateur dépend de l'application et, notamment des conditions de fonctionnement en courant du circuit.

Un intérêt du triac est qu'il est bidirectionnel et permet donc une ouverture ou une fermeture sur des alternances négatives ou positives de la tension Vac. Toutefois, le triac nécessite un courant de gâchette important (généralement de l'ordre de 10 à 20 milliampères). Par exemple, on aura recours à des triacs lorsque les impulsions de commande peuvent être de durée suffisamment courtes pour minimiser la consommation malgré ce courant de gâchette important.

Les thyristors présentent l'avantage de requérir des courants de gâchette nettement inférieurs (généralement de l'ordre de 100 µA) à ceux d'un triac. Toutefois, ils présentent l'inconvénient d'être unidirectionnels, ce qui entraîne que les impulsions de commande doivent être d'une durée supérieure à la demi période de la tension Vac pour garantir un amorçage sur une alternance positive. Par exemple, le recours à des thyristors sera choisi quand l'utilisation d'impulsions de longues durées ne fait pas perdre le bénéfice d'un courant de commande plus faible par rapport à l'utilisation de triacs.

On notera que dans les modes de réalisation des figures 3 et 5, le triac T2 ou le thyristor Th2 remplit intrinsèquement la condition d'attendre le passage par 0 de la tension Vac pour s'ouvrir. Par conséquent, la condition exposée en relation avec la figure 2, que l'interrupteur S2 soit fermé jusqu'au passage par zéro de la tension Vac, ne nécessite pas d'adaptation du signal V_{OFF}. La seule condition à respecter est alors une durée suffisante pour décharger le condensateur C.

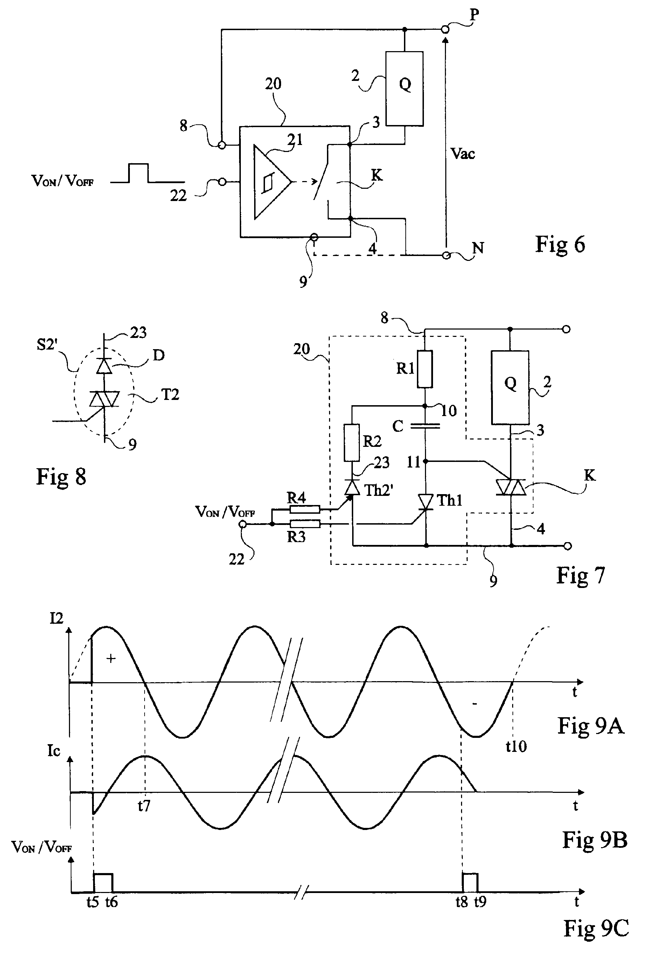

La figure 6 représente, de façon schématique et sous forme de blocs, un mode de réalisation d'un commutateur 20 selon un deuxième aspect de la présente invention. Comme précédemment, ce commutateur comprend deux bornes 3, 4 de puissance et est destiné à être connecté en série avec une charge 2 (Q) alimentée par une tension alternative Vac. Comme dans le premier aspect de l'invention, le commutateur 20 comprend un élément de commutation bidirectionnel K entre les bornes 3 et 4, cet élément étant préférentiellement constitué d'un triac. Le commutateur 20 comporte, comme dans le premier aspect de l'invention, une borne 8 destinée à être reliée à la phase P de la tension Vac et, le cas échéant une borne 9 destinée à être reliée au neutre N.

Selon le deuxième aspect de l'invention illustré par la figure 6, un circuit 21 de commande de l'élément K est prévu au sein du commutateur 20. Une caractéristique de ce circuit est, outre de tirer son alimentation directement de la tension Vac, de ne comporter qu'une seule borne 22 de commande par un signal impulsionnel basse tension V_{ON/OFF}. Ainsi, selon le deuxième aspect de l'invention, le commutateur 20 est commandé par un signal unique et change d'état à chaque apparition d'une impulsion sur ce signal unique.

Une caractéristique de ce signal de commande est d'être synchronisé sur la tension d'alimentation alternative Vac de façon que les impulsions de fermeture (ou d'ouverture) soient présentes sur les alternances positives (ou négatives) de la tension Vac.

La figure 7 représente un mode de réalisation d'un commutateur 20 selon le deuxième aspect de l'invention.

La structure du commutateur ressemble fortement à celle exposée en relation avec les figures 3 et 5. Un premier interrupteur de l'élément de commande 21 est connecté en série avec un condensateur C et une résistance R1 entre les bornes 8 et 9. Dans l'exemple de la figure 7, cet interrupteur est un thyristor Th1. On notera toutefois qu'il pourra s'agir d'un triac comme dans le mode de réalisation de la figure 3. L'élément K est comme précédemment connecté entre les bornes 3 et 4 et a sa gâchette reliée au noeud 11 entre le condensateur C et le thyristor Th1. De même, un deuxième interrupteur est connecté en série avec une résistance R2 entre le noeud 10, commun à la résistance R1 et le condensateur C, et la borne 9.

Une caractéristique du mode de réalisation de la figure 7 est que le deuxième interrupteur est un thyristor Th2' à gâchette d'anode et à courant de déclenchement entrant, c'est-à-dire que l'anode du thyristor Th2' est connectée à la borne 9 alors que, dans le mode de réalisation de la figure 5, c'est la cathode du thyristor Th2 qui est connectée à la borne 9.

Les gâchettes respectives des thyristors Th1 et Th2' sont reliées par l'intermédiaire de résistances respectives R3 et R4 de conversion tension/courant, à la borne commune 22 d'application du signal basse tension V_{ON/OFF}.

La figure 8 représente, très partiellement, un deuxième mode de réalisation d'un commutateur 20 selon l'invention qui illustre un mode de réalisation d'un commutateur S2' au moyen d'un triac T2 en série avec une diode D entre la borne 9 et la borne 23 de la résistance R2 opposée à la borne 10. La diode D a pour objet de rendre unidirectionnel le triac T2 de sorte que le montage de la figure 8 revient, fonctionnellement, au thyristor Th2' de la figure 7.

Les figures 9A à 9C illustrent, sous forme de chronogrammes, le fonctionnement d'un commutateur 20 selon le second aspect de l'invention. La figure 9A représente un exemple d'allure du courant I₂ dans la charge 2. La figure 9B représente le courant Ic dans le condensateur C. La figure 9C représente l'allure de la tension V_{ON/OFF} appliquée sur la borne 22.

Dans l'exemple représenté, la fermeture du commutateur 20 intervient uniquement lors d'alternances positives de la tension Vac. Par souci de simplification, on a supposé qu'il n'y avait de déphasage entre la tension Vac et le courant dans la charge. On notera toutefois qu'en cas de déphasage, le fonctionnement du commutateur de l'invention n'en est pas affecté dans la mesure où la condition de disposer d'un courant non nul dans le condensateur C au passage par zéro de la tension Vac reste respectée.

On suppose le commutateur 20 initialement fermé et l'apparition d'une impulsion de tension positive sur le signal V_{ON/OFF} (instants t5 à t6) pendant une alternance positive de la tension Vac. A l'instant t5, le thyristor Th1 se ferme, autorisant par voie de conséquence la fermeture du triac K et le début de charge du condensateur C. Indépendamment de la durée de l'impulsion, le thyristor Thl s'ouvre à un instant t7 correspondant au passage par zéro de la tension Vac. Toutefois, le triac K est réamorcé au début de l'alternance négative qui suit grâce au courant Ic dans le condensateur C. On notera que le deuxième interrupteur S2' n'a pas pu entrer en conduction lors de l'impulsion en raison de son caractère unidirectionnel.

Pour ouvrir le commutateur 20, on provoque une impulsion (instants t8 à t9) sur le signal V_{ON/OFF} pendant une alternance négative de la tension Vac. Il en découle que le thyristor Th1 reste bloqué mais que le thyristor Th2' (ou le triac T2) est rendu conducteur provoquant ainsi la décharge du condensateur C. Par conséquent, à la fin de l'alternance négative concernée (instant t10), lorsque le thyristor Th2' se bloque indépendamment de ce qu'est devenue l'impulsion du signal de commande, le triac K se bloque également sans pouvoir être réamorcé car le courant Ic a disparu.

Les durées respectives des impulsions du signal V_{ON/OFF} doivent être suffisamment courtes pour ne pas chevaucher deux alternances. En effet, si la première alternance de fermeture se prolonge jusqu'à l'alternance négative suivante, elle va provoquer immédiatement la réouverture du commutateur.

Toutefois, comme la génération des impulsions du signal de commande a besoin d'être synchronisée sur la tension Vac, il n'est pas difficile de faire en sorte qu'elles apparaissent suffisamment tôt par rapport à l'alternance en fonction de leur durée. La durée de l'impulsion d'ouverture est, comme précédemment, conditionnée par le temps nécessaire à la décharge du condensateur C et la durée de l'impulsion de fermeture est, comme précédemment, conditionnée par la durée nécessaire à l'amorçage du triac K et à la charge du condensateur C.

Un avantage de la présente invention est qu'elle permet la réalisation d'un commutateur bidirectionnel haute tension stable tout en étant commandé par une simple impulsion à chaque changement d'état.

Un autre avantage de l'invention est qu'elle minimise le recours au microcontrôleur éventuel partagé entre la génération du signal de commande nécessaire au fonctionnement du commutateur et d'autres fonctions.

Un autre avantage de l'invention est qu'elle minimise la dissipation liée à la génération des signaux de commande. En effet, l'énergie nécessaire au maintien dans un état ouvert ou fermé du commutateur est désormais fournie directement par la tension alternative sans qu'il y ait conversion de tension.

La résistance R1 doit tenir la haute tension alternative alors que la résistance R2 ne voit au maximum que la tension aux bornes du condensateur C. Pour le choix de la résistance R1, on effectue un compromis entre le besoin d'amorçage rapide qui nécessite une valeur faible et une dissipation minimale qui nécessite une valeur forte.

On notera que, dans le cas d'un fonctionnement synchronisé, la synchronisation des signaux de commande ne pose pas un problème dans la mesure où cette synchronisation s'effectue sur un signal (la tension Vac) présent par ailleurs.

On notera également que tous les constituants du commutateur de l'invention sont intégrables à l'exception, le cas échéant, de la résistance R1 et du condensateur C.

La présente invention trouve un intérêt tout particulier dans des applications d'électroménager, par exemple de type machine à laver, dans lesquelles plusieurs charges (moteurs, pompes, résistances chauffantes, vannes) doivent être commandées à partir du microcontrôleur de la machine. Plus généralement, l'invention trouve un intérêt tout particulier dans tout équipement électroménager où des microcontrôleurs basse tension sont de plus en plus souvent présents. Un commutateur selon l'invention remplace alors chaque triac classique.

Bien entendu, la présente invention est susceptible de diverses variantes et modifications qui apparaîtront à l'homme de l'art. En particulier, les dimensionnements respectifs des divers constituants du commutateur dépendent de l'application (en particulier des courants et tensions de puissance et de commande) et des caractéristiques souhaitées en terme de consommation et de dissipation. De plus, l'obtention des signaux de commande basse tension du commutateur et leur synchronisation éventuelle n'ont pas été détaillées car elles sont à la portée de l'homme du métier à partir des indications fonctionnelles données ci-dessus et du fonctionnement souhaité. En outre, bien que l'invention ait été décrite ci-dessus en relation avec des thyristors ou des triacs, d'autres composants ayant des fonctions équivalentes pourront être utilisés pour réaliser des interrupteurs de l'élément de commande du commutateur.

## Revendications

1. Commutateur bidirectionnel haute tension (1' 1" ; 20), comprenant :
un élément (K) de commutation bidirectionnel haute tension ; et
deux interrupteurs (T1, T2 ; Th1, Th2 ; Th1, Th'2) destinés à rendre l'élément de commutation commandable par au plus deux signaux impulsionnels (V_{ON}, V_{OFF} ; V_{ON/OFF}),
caractérisé en ce que :
un premier interrupteur (T1, Th1) est connecté en série avec un condensateur (C) et une première résistance (R1), entre deux bornes (8, 9) du commutateur propres à recevoir la haute tension alternative (Vac) ; et
un deuxième interrupteur (T2, Th2, Th2') est connecté en série avec une deuxième résistance (R2), cette connexion en série étant connectée en parallèle avec la connexion en série du condensateur (C) et du premier interrupteur (T1, Th1).

2. Commutateur selon la revendication 1, caractérisé en ce que la fréquence des signaux impulsionnels (V_{ON}, V_{OFF} ; V_{ON/OFF}) est faible devant la fréquence de la haute tension alternative (Vac), la durée des impulsions étant faible devant la période de cette haute tension alternative.

3. Commutateur selon la revendication 1 ou 2, caractérisé en ce que le condensateur (C) est dimensionné pour stocker une énergie suffisante pour réamorcer l'élément de commutation bidirectionnel (K) à chaque alternance de la haute tension (Vac).

4. Commutateur selon l'une quelconque des revendications 1 à 3, caractérisé en ce que ledit premier interrupteur est destiné à provoquer, par sa fermeture, la fermeture de l'élément de commutation bidirectionnel (K), ledit deuxième interrupteur étant destiné, lors de sa fermeture, à décharger le condensateur (C) pour empêcher un réamorçage automatique de l'élément de commutation bidirectionnel (K).

5. Commutateur (20) selon l'une quelconque des revendications 1 à 4, caractérisé en ce que les deux interrupteurs sont commandés par un signal de commande unique (V_{ON/OFF}), chaque interrupteur (Th1 ; Th2', S2') étant unidirectionnel et correspondant à un sens particulier de conduction.

6. Commutateur selon la revendication 5, caractérisé en ce que ledit signal unique de commande (V_{ON/OFF}) est synchronisé sur la haute tension alternative (Vac), les impulsions apparaissant lors d'un premier signe des alternances étant destinées à provoquer la fermeture du commutateur (20) et les impulsions apparaissant lors d'un deuxième signe d'alternance étant destinées à provoquer son ouverture.
